# EUROPÄISCHE PATENTSCHRIFT

(11) **EP 3 545 360 B1**
(45) Veröffentlichungstag und Bekanntmachung des Hinweises auf die Patenterteilung: **17.03.2021**
(21) Anmeldenummer: 17811248.8
(22) Anmeldetag: 27.11.2017
(51) Int. Cl.: G03F 7/20, G03F 7/24

(54) **BELICHTUNGSVORRICHTUNG UND VERFAHREN ZUR BELICHTUNG VON PLATTENFÖRMIGEN MATERIALIEN**
IMAGING DEVICE AND METHOD FOR IMAGING PLATE-SHAPED MATERIALS
DISPOSITIF D'ÉCLAIRAGE ET PROCÉDÉ D'ÉCLAIRAGE DE MATÉRIAUX LAMELLAIRES

(30) Priorität: 28.11.2016 EP 16200954
(43) Veröffentlichungstag der Anmeldung: 02.10.2019
(73) Patentinhaber: Flint Group Germany GmbH, 70469 Stuttgart (DE)
(72) Erfinder: BOYKSEN, Frank, 71155 Altdorf (DE)
(74) Vertreter: Arnold & Siedsma
(86) Internationale Anmeldenummer: PCT/EP2017/080523
(87) Internationale Veröffentlichungsnummer: WO 2018/096144

(56) Entgegenhaltungen:
- EP-A1- 3 054 349
- WO-A1-2015/044437
- WO-A1-2015/060972
- US-A1- 2016 088 868
- US-B1- 6 211 942

## Beschreibung

Die Erfindung betrifft eine Belichtungsvorrichtung zur Belichtung von plattenförmigen Materialien, Verfahren zur Belichtung von plattenförmigen Materialien und eine Druckform, welche gemäß einem der Verfahren aus einem plattenförmigen Material hergestellt wurde.

Bei dem plattenförmigen Material handelt es sich insbesondere um zur Herstellung von Druckformen geeignete Druckelemente. Im Stand der Technik sind solche Druckelemente prinzipiell bekannt. Sie umfassen mindestens einen dimensionsstabilen Träger und eine reliefbildende Schicht. Zusätzlich können die Druckformen eine bebilderbare Schicht aufweisen, bei der es sich beispielsweise um eine laserablatierbare Schicht, um eine mittels Ink-Jet-Drucker beschreibbare Schicht oder um eine thermographische Schicht handeln kann, wobei laserablatierbare Schichten, auch LAMS (laserablatierbare Maskenschichten) genannt, am gebräuchlichsten sind. Für die reliefbildende Schicht ist die Verwendung von fotopolymerisierbaren Schichten gebräuchlich. Weiterhin kommen üblicherweise Sperr- oder Barriereschichten zum Einsatz, um unerwünschte Substanzen, wie beispielsweise Wasser und/oder Sauerstoff fern zu halten.

Die Herstellung von Druckformen ausgehend von derartigen Druckelementen erfolgt mittels eines mehrstufigen Prozesses unter Verwendung entsprechender Vorrichtungen für jeden Verfahrensschritt.

Bei Verwendung eines Druckelements mit laserablatierbarer Schicht wird zunächst eine Maske in die bebilderbare Schicht unter Verwendung eines IR-Lasers eingeschrieben. Es kann sich hierbei um Laserapparaturen mit rotierender Trommel, Flachbettapparaturen oder Innentrommellaser handeln.

Nach dem Einschreiben der Maske wird das Druckelement durch die gebildete Maske hindurch mit UV-Strahlung bzw. UV/VIS-Strahlung belichtet. Die fotopolymerisierbare Schicht polymerisiert in den von der Maske nicht mehr abgedeckten Bereichen, während in den abgedeckten Bereichen keine Polymerisation erfolgt. Hierfür werden UV-Belichter verwendet, welche verschiedene UV-Quellen umfassen können, beispielsweise UV-Röhren oder UV-LEDs.

Nach der Belichtung werden die Reste der Maske sowie die nicht polymerisierten Anteile der fotopolymerisierbaren Schicht entfernt. Dies kann unter Verwendung von einem oder mehreren Lösemitteln oder auch thermisch erfolgen. Zum Auswaschen mittels Lösemittel und/oder Wasser bzw. wässrigen Lösungen werden spezielle Wascher, z.B. Bürstenwascher verwendet. Zum thermischen Entwickeln können Entwickler verwendet werden, bei denen ein Entwicklungsmedium (beispielsweise ein saugfähiges Vlies) mit der verflüssigen unbelichteten Schicht in Kontakt gebracht und entfernt wird. Bei Verwendung von Lösemitteln zum Entwickeln der Platte schließt sich ein Trockenschritt in einem Trockner an.

Im Stand der Technik sind Vorrichtungen und Verfahren zur Durchführung der Belichtung bekannt. Aus WO 2016/096945 A1 ist ein Verfahren und eine entsprechende Vorrichtung bekannt, bei dem zur Herstellung von Flexodruckformen eine Mehrfachbelichtung mit LEDs (lichtemittierenden Dioden) unter Einsatz von unterschiedlichen Belichtungsintensitäten in mehreren Belichtungszyklen durchgeführt wird. Die einzelnen Belichtungszyklen werden dadurch realisiert, dass UV-LEDs parallel zur Oberfläche eines Flexodruckelements bewegt werden. Die UV-LEDs sind auf einer oder mehreren LED-Leisten angeordnet, die parallel zur Oberfläche des Flexodruckelements bewegt werden. Dabei können die LEDs fest installiert sein und das Flexodruckelement bewegt werden oder umgekehrt das Flexodruckelement während der Belichtung ruhen und die LEDs bewegt werden. Des Weiteren kann mindestens eine der LED-Leisten feststehend und weitere LED-Leisten können beweglich angeordnet sein.

Aus WO2012/010459 A1 ist eine Vorrichtung zur in-line-Produktion von Flexodruckplatten mittels digitaler Bebilderung bekannt. Die Vorrichtung umfasst eine erste Belichtungseinheit umfassend eine Mehrzahl von in einem Array angeordneten LEDs, welche UV-Licht mit einer Intensität von ≥ 100 mW/cm² emittieren kann sowie eine zweite Belichtungseinheit, umfassend eine von LEDs verschiedene UV-Strahlungsquelle, bevorzugt eine UV-Röhre oder einen UV-Strahler. Das Belichten erfolgt in einem ersten Belichtungsschritt mit einer Intensität von ≥ 100 mW/cm² und einem zweiten Belichtungsschritt mit einer Intensität von < 100 mW/cm².

Aus US 2011/0104615 A1 sind Vorrichtungen und Verfahren zum Belichten einer Druckplatte bekannt. In einer Ausführungsvariante werden Druckplatten auf einer rotierenden Trommel angeordnet und während einer Drehung der Trommel mit einer UV-Quelle, beispielsweise ein LED Array, belichtet. In einer Variante wird die UV-Quelle in einer Richtung parallel zur Achse der Trommel verschoben. In einer weiteren Ausführungsform entspricht die Länge der UV-Lichtquelle der Länge der Trommel und es ist keine Bewegung der UV-Lichtquelle vorgesehen, lediglich die Trommel rotiert.

Aus US 8,762,740 B2 ist eine Belichtungsvorrichtung bekannt, welche eine Trommel, eine UV-Lichtquelle und eine Abbildungseinheit umfasst. Des Weiteren wird ein Verfahren beschrieben, bei dem über einen Laser der Abbildungseinheit eine Maske geschrieben wird und über die UV-Lichtquelle eine Belichtung durchgeführt wird, die zur Ausbildung von Oberflächenstrukturen mit flachen Oberflächen (Flat Top Dots, FTD) führt. Anschließend wird eine weitere Maske geschrieben und eine Belichtung durchgeführt, die zur Ausbildung von Oberflächenstrukturen mit runden Oberflächen (Round Top Dots) führt. Durch das mehrfache Schreiben von Masken ist das Verfahren sehr aufwändig.

Aus US 8,578,854 B2 ist ein Verfahren zur UV-LED Belichtung von Flexodruckplatten bekannt, bei dem sich eine UV-LED-Belichtungseinheit in einem Reflektortunnel befindet. In dem Reflektortunnel wird die UV-Strahlung zusätzlichen gestreut, wodurch sich Rasterpunkte mit breiter Versockelung realisieren lassen.

Das Dokument WO 2014/035566 A1 beschreibt eine Flexodruckplatte, die mittels UV-LEDs belichtet wird, wobei die Belichtung mit zwei UV-LED Anordnungen erfolgt. Die zwei UV-LED Anordnungen weisen bevorzugt unterschiedliche Wellenlängen auf.

Aus US 6,211,942 B1 ist ein System zum doppelseitigen Belichten von Substraten bekannt. Die Vorrichtung umfasst eine einzige UV-Lichtquelle wobei das Licht der Lampe auf einen rotierbaren Spiegel gerichtet ist. Durch Drehen des Spiegels kann das Licht der Lampe in zwei verschiedene Richtungen geleitet werden, wobei mit dem Spiegel in einer ersten Position UV-Licht durch eine erste Maske auf eine erste Seite des Substrats geleitet wird und mit dem Spiegel in einer zweiten Position UV-Licht durch eine zweite Maske auf die zweite Seite des Substrats geleitet wird. Ein Bewegen oder Drehen der UV-Lichtquelle selbst ist nicht vorgesehen.

Bei der Herstellung von Druckformen aus einem plattenförmigen Material ist es in der Regel erforderlich, sowohl deren Vorderseite als auch deren Rückseite zu belichten. Bei bekannten Belichtungsvorrichtungen ist hierzu ein Wenden des plattenförmigen Materials erforderlich, was Zeit und Platz erfordert. Des Weiteren besteht bei dem Wenden die Gefahr, das plattenförmige Material zu beschädigen. Zudem ist ein manuelles Wenden des plattenförmigen Materials personalintensiv.

Eine Aufgabe der Erfindung kann somit darin gesehen werden, eine Vorrichtung sowie ein Verfahren bereitzustellen, mit dem sich beide Seiten eines plattenförmigen Materials ohne ein manuelles Wenden belichten lassen.

Belichtungsvorrichtungen, welche für beide Seiten des plattenförmigen Materials jeweils eine Belichtungseinheit vorsehen, sind aufwändig. Werden dabei für die Belichtung beide Seiten LEDs als Lichtquelle vorgesehen, so ergeben sich zusätzlich hohe Kosten, da UV-LEDs mit hoher Leistung sehr teuer sind.

Eine weitere Aufgabe der Erfindung kann somit darin gesehen werden, eine verbesserte Belichtungsvorrichtung bereitzustellen, bei der die Anzahl der benötigten Belichtungseinheiten reduziert ist.

### Offenbarung der Erfindung

Es wird eine Belichtungsvorrichtung zur Belichtung von plattenförmigen Materialien vorgeschlagen. Das plattenförmige Material weist eine erste Seite und eine der ersten Seite gegenüberliegende zweite Seite auf. Die Belichtungsvorrichtung umfasst eine erste Belichtungseinheit und eine Transporteinheit, wobei die erste Belichtungseinheit um eine Achse drehbar ausgeführt ist, wobei die erste Belichtungseinheit durch Drehen um die Achse eine erste Position und eine zweite Position einnehmen kann und die erste Belichtungseinheit sowie die Transporteinheit derart eingerichtet sind, dass in einer ersten Position der ersten Belichtungseinheit die erste Seite des plattenförmigen Materials für eine Belichtung zugeführt und an der ersten Belichtungseinheit vorbeibewegt wird und in einer zweiten Position der ersten Belichtungseinheit die zweite Seite des plattenförmigen Materials für eine Belichtung zugeführt und an der ersten Belichtungseinheit vorbeibewegt wird.

Bei dem plattenförmigen Material handelt es sich bevorzugt um Druckelemente und besonders bevorzugt um Flexodruckelemente, die zu Druckformen bzw. zu Flexodruckformen verarbeitet werden. Der Begriff "erste Seite" des plattenförmigen Materials kann die Vorderseite oder die Rückseite des plattenförmigen Materials bezeichnen, wobei der Begriff "zweite Seite" entsprechend die andere Seite des plattenförmigen Materials bezeichnet.

Zur Verarbeitung mit der erfindungsgemäßen Belichtungsvorrichtung werden bevorzugt fotopolymerisierbare Druckelemente als plattenförmiges Material verwendet. Insbesondere können alle fotopolymerisierbaren Flexodruckelemente verwendet werden, welche mindestens einen dimensionsstabilen Träger, eine - bevorzugt in organischen Auswaschmitteln auswaschbare- reliefbildende, fotopolymerisierbare Schicht sowie eine bebilderbare Schicht umfassen. Bevorzugt werden Druckelemente, die eine digital bebilderbare Schicht umfassen.

Plattenförmige, digital bebilderbare Flexodruckelemente sind dem Fachmann prinzipiell bekannt, und sie sind kommerziell erhältlich. Beispiele derartiger Flexodruckelemente sind beispielsweise in US 5,262,275, EP-A 1 069 475, WO 2008/095994 A1, WO 2009/141256 A1 oder WO 2012/010459 A1 beschrieben. Der Fachmann trifft je nach den gewünschten Eigenschaften der Flexodruckplatte eine geeignete Auswahl.

Zur Verarbeitung in der erfindungsgemäßen Vorrichtung können bevorzugt Flexodruckelemente mit einer Trägerfolie mit einer Dicke von 50 bis 300 µm eingesetzt werden. In aller Regel handelt es sich um eine Trägerfolie aus einem für UV-Licht zumindest teilweise transparenten Material, um die Rückseitenvorbelichtung des Flexodruckelements zu erlauben. Geeignet sind insbesondere PET-Folien.

Die fotopolymerisierbare, reliefbildende Schicht umfasst in prinzipiell bekannter Art und Weise mindestens ein elastomeres Bindemittel, ein ethylenisch ungesättigtes Monomer sowie einen Fotoinitiator oder ein Fotoinitiatorsystem. Neben den genannten Komponenten können optional noch weitere Komponenten wie beispielsweise Weichmacher vorhanden sein. Bevorzugt handelt es sich um eine in organischen Auswaschmitteln oder in Wasser bzw. wässrigen Lösungen lösliche oder eine durch Temperaturerhöhung verflüssigbare Schicht, aber selbstverständlich können auch Flexodruckelemente mit wasserlöslichen, reliefbildenden Schichten in der erfindungsgemäßen Vorrichtung verarbeitet werden. Bei den elastomeren Bindemitteln kann es sich beispielsweise um thermoplastisch-elastomere Blockcopolymere, beispielsweise Styrol-Butadien- oder Styrol-Isopren-Blockcopolymere handeln. Die reliefbildende Schicht weist in der Regel eine Schichtdicke von 300 µm bis 7000 µm, bevorzugt 1000 µm bis 5000 µm auf. Selbstverständlich können eingesetzte Flexodruckelement auch mehrere fotopolymerisierbare, reliefbildende Schichten verschiedener Zusammensetzung übereinander umfassen.

Bei der digital bebilderbaren Schicht kann es sich beispielsweise um eine laserablatierbare Schicht, um eine mittels Ink-Jet-Drucker beschreibbare Schicht oder um eine thermographische Schicht handeln. Bevorzugt handelt es sich um eine laserablatierbare Schicht.

Die laserablatierbare Maskenschicht, auch LAMS-Schicht genannt, umfasst mindestens ein elastisches Bindemittel, insbesondere ein weichelastisches Bindemittel. Selbstverständlich können auch Gemische mehrerer verschiedener Bindemittel eingesetzt werden. Beispiele geeigneter Bindemittel umfassen weichelastische Polyamide. Derartige Polyamide umfassen als monomere Bausteine langkettige, bifunktionelle Fettsäuren, die dem Polyamid weichelastische Eigenschaften verleihen. Weiterhin können Polyesteramide, Cellulosederivate, Nitrocellulose, Polyvinylalkohole, Polyvinylacetat, Ethylenvinylacetatcopolymere, Polyacrylate oder Mischungen der genannten Polymere eingesetzt werden, sofern sie weichelastische Eigenschaften besitzen.

Die laserablatierbare Maskenschicht umfasst weiterhin UV- und/oder IR absorbierende Materialien. Als absorbierendes Material eignet sich insbesondere feinteiliger Ruß. Ruß absorbiert sehr gut sowohl im UV- als auch im IR-Bereich und gewährleistet somit bei der Bebilderung mittels IR-Laser gleichzeitig auch eine schnelle Bebilderung. Selbstverständlich kann die laserablatierbare Maskenschicht aber auch andere UV- und/oder IR- Absorber auf Pigmentbasis oder lösliche Farbstoffe enthalten. Ruß ist üblicherweise in einer Menge von 10 bis 50 Gew.-% bezüglich der Summe aller Komponenten enthalten. Die Schichtdicke der Maskenschicht sollte einige wenige µm, bevorzugt 1 µm bis 4 µm betragen.

Zum Schutz der Maskenschicht weist das Flexodruckelement üblicherweise eine Deckfolie auf.

Darüber hinaus kann das Flexodruckelement optional noch weitere Schichten umfassen, wie beispielsweise elastische Unterschichten, Haftschichten oder entklebende Schichten.

Zwischen der fotopolymerisierbaren Schicht und der laserablatierbaren Schicht kann weiterhin optional eine für UVA-Licht transparente Barriereschicht für Sauerstoff angeordnet sein. Eine derartige Schicht limitiert oder verhindert während des Belichtens die Diffusion von Sauerstoff in die fotopolymerisierbare Schicht und trägt somit zu einem besseren Druckbild bei. Die Barriereschicht kann in prinzipiell bekannter Art und Weise ein polymeres Bindemittel mit einer niedrigen Durchlässigkeit für Sauerstoff umfassen. Beispiele geeigneter Bindemittel umfassen Polyamide, Polyvinylalkohol, Hydroxyalkylcellulose, Polyvinylpyrrolidon, Polyvinylacetat, Ethylen-Vinylacetat-Copolymere, amphotere Interpolymere, Celluloseacetatbutyrat, Alkylcellullose, Butyral, cyclische Kautschuke oder Kombinationen davon. Eine Barriereschicht weist üblicherweise eine Schichtdicke von 0,3 µm bis 5 µm auf. Weitere Einzelheiten zu Barriereschichten sind beispielsweise in US 5,262,275 oder WO 2012/145111 A1 offenbart.

Die erste Belichtungseinheit umfasst mindestens eine Lichtquelle. Unter "Drehen der Belichtungseinheit" wird verstanden, dass diese als Ganzes, also einschließlich der mindestens einen Lichtquelle gedreht wird. Somit wird beim Drehen der Belichtungseinheit die mindestens eine Lichtquelle ebenfalls gedreht bzw. neu ausgerichtet. Bevorzugt erfolgt die Belichtung des plattenförmigen Materials direkt, wobei unter einer direkten Belichtung verstanden wird, dass das Licht der Lichtquelle der Belichtungseinheit nicht über reflektierende Elemente wie Spiegel gelenkt wird. Direkte Belichtung bedeutet in diesem Fall auch, dass zwischen der Lichtquelle und dem plattenförmigen Material sich feste oder flüssige transparente oder semitransparente Materialien befinden können. Flüssige Materialien sind dabei zwischen festen Schichten angebracht und können zusätzlich zur Temperierung des transparenten Materials eingesetzt werden. Vorzugsweise handelt es sich dabei um Wasser, wässrige Lösungen, Emulsionen oder Dispersionen oder organische Lösungsmittel. Feste Materialien sind ausgewählt aus der Gruppe von Kunststoffen, Gläsern, Filtern und Kombinationen davon. Als Kunststoffe und Gläser werden bevorzugt Polymere und anorganische Gläser verwendet, die im UV-Bereich transparent sind und ggf. andere Wellenlängenbereiche durch den Einsatz entsprechender Absorber oder Zusätze filtern oder blockieren. Bevorzugt werden Quarz, Silikate, Polyene (z.B. Polyethylen, Polypropylen, Teflon), Polycarbonate, Polyester, Polyurethane, Polyamide oder Kombinationen davon eingesetzt.

Die Transporteinheit ist bevorzugt für einen kontinuierlichen oder einen diskontinuierlichen Transport von plattenförmigen Materialien durch die Belichtungsvorrichtung eingerichtet. Bei einem kontinuierlichen Transport erfolgt die Belichtung der plattenförmigen Materialien während diese relativ zu der jeweiligen Belichtungseinheit in Bewegung sind. Bei einem diskontinuierlichen Transport erfolgt die Belichtung bevorzugt dann, wenn die plattenförmigen Materialien gerade nicht transportiert werden und somit mit Bezug auf die jeweilige Belichtungseinheit in Ruhe sind.

Bevorzugt umfasst die Transporteinheit eine rotierbare Trommel, wobei die Drehachse der ersten Belichtungseinheit parallel zur Rotationsachse der Trommel verläuft. Alternativ oder zusätzlich zu einer rotierbaren Trommel kann die Transporteinheit ein Endlostransportband umfassen, wobei die Drehachse der ersten Belichtungseinheit bevorzugt senkrecht zu einer Transportrichtung des Endlostransportbandes und parallel zu einer Ebene des Endlostransportbandes ausgerichtet ist.

Bevorzugt weist die erste Belichtungseinheit in einer ihrer Positionen, beispielsweise in der zweiten Position, auf die Trommel bzw. das Endlostransportband, so dass ein auf der Trommel bzw. dem Endlostransportband aufgenommenes plattenförmiges Material durch die erste Belichtungseinheit belichtet werden kann. In der jeweils anderen Position weist die erste Belichtungseinheit bevorzugt nicht auf die Trommel bzw. auf das Endlostransportband.

Die rotierbare Trommel und/oder das Endlostransportband weist bevorzugt mindestens eine Befestigungsvorrichtung für plattenförmige Materialien ausgewählt aus einer Befestigungsleiste, einer Klemmvorrichtung, einer Vakuum Saugbefestigung, Stanzlöchern, Stanzen oder einer Kombination mehrerer Befestigungsvorrichtungen auf.

Für den Transport des plattenförmigen Materials kann die Transporteinheit beispielsweise Transportbänder oder Transportwalzen umfassen oder die Transporteinheit kann Transportmittel umfassen, mit denen das plattenförmige Material mittels Transportketten, Spindeln oder dergleichen durch die Belichtungsvorrichtung gezogen oder geschoben werden kann. Die Transportbänder, Transportwalzen oder weiteren Transportmittel werden bevorzugt zusätzlich zu einer rotierbaren Trommel und/oder einem Endlostransportband vorgesehen.

In einer weiteren bevorzugten Ausführungsform sind neben einer rotierbaren Trommel oder einem Endlostransportband keine zusätzlichen Transportbänder, Transportwalzen oder weitere Transportmittel vorgesehen.

Die erste Belichtungseinheit ist so ausgestaltet und angeordnet, dass diese um eine Drehachse drehbar ist. Unter dem Begriff drehbar wird dabei auch eine Schwenkbewegung um eine Achse oder eine Klappbewegung um eine Achse verstanden. Die erste Belichtungseinheit kann durch Drehung um die Drehachse mehrere verschiedene Positionen einnehmen. Dabei ist vorgesehen, dass die erste Belichtungseinheit durch Drehen um die Drehachse zumindest in eine erste Position gedreht werden kann und durch Drehen um diese Drehachse in eine zweite Position gedreht werden kann. Für das Ausführen der Drehbewegung ist bevorzugt ein entsprechender Aktor vorgesehen.

Die Transporteinheit und die erste Belichtungseinheit wirken so zusammen, dass die Transporteinheit das Material der ersten Belichtungseinheit so zuführt, dass die erste Belichtungseinheit auf das plattenförmige Material gerichtet ist. Bevorzugt steht dabei die erste Belichtungseinheit sowohl in der ersten Position als auch in der zweiten Position im Wesentlichen senkrecht zu der Ebene des plattenförmigen Materials. Ist die erste Belichtungseinheit in der ersten Position, so weist diese auf die erste Seite des plattenförmigen Materials. Ist die erste Belichtungseinheit in der zweiten Position, so weist diese auf die zweite Seite des plattenförmigen Materials. Mit im Wesentlichen senkrecht ist hier gemeint, dass geringe Abweichungen von einem 90° Winkel zur Ebene des plattenförmigen Materials im Bereich von +/- 30° möglich sind.

Auf diese Weise kann mit einer einzigen ersten Belichtungseinheit sowohl eine Belichtung der ersten Seite als auch der zweiten Seite des plattenförmigen Materials erfolgen. Je nach Ausgestaltung der Vorrichtung kann dabei vorgesehen sein, dass zuerst die erste Seite und anschließend die zweite Seite des plattenförmigen Materials belichtet werden oder umgekehrt zuerst die zweite Seite und anschließend die erste Seite des plattenförmigen Materials durch die erste Belichtungseinheit belichtet werden.

Durch die Möglichkeit, die erste Belichtungseinheit von einer ersten Position, in der eine Belichtung der ersten Seite des plattenförmigen Materials möglich ist, in eine zweite Position zu bewegen, in der eine Belichtung der zweiten Seite des plattenförmigen Materials möglich ist, kann die Belichtungsvorrichtung besonders einfach und kompakt ausgestaltet werden, da beide Seiten des plattenförmigen Materials unter Verwendung von einer einzigen Belichtungseinheit belichtet werden können.

Bevorzugt umfasst die Belichtungsvorrichtung mindestens eine weitere Belichtungseinheit. Die mindestens eine weitere Belichtungseinheit ist bevorzugt unbeweglich ausgestaltet oder ist nur für eine Bewegung in eine Richtung quer zur Transportrichtung und parallel zur Ebene des plattenförmigen Materials eingerichtet. Durch das Bewegen quer zur Transportrichtung kann eine Belichtungseinheit eingesetzt werden, die nicht die gesamte Breite des plattenförmigen Materials auf einmal belichten kann.

Je nach Ausgestaltung der Belichtungsvorrichtung kann die erste Belichtungseinheit die einzige Belichtungseinheit sein oder es können zusätzlich zu der ersten Belichtungseinheit im Bereich von 1 bis 100, bevorzugt im Bereich von 2 bis 10, weitere Belichtungseinheiten vorgesehen sein. Diese können an verschiedenen Positionen in der Belichtungsvorrichtung angeordnet sein.

Bevorzugt sind die erste Belichtungseinheit und/oder die mindestens eine weitere Belichtungseinheit eingerichtet eine streifenförmige Fläche des plattenförmigen Materials zu belichten, wobei die lange Seite der streifenförmigen Fläche senkrecht zu einer Transportrichtung des plattenförmigen Materials orientiert ist. Besonders bevorzugt entspricht die Länge der langen Seite der streifenförmigen Fläche mindestens der Breite des plattenförmigen Materials, so dass die gesamte Breite des plattenförmigen Materials auf einmal belichtet werden kann.

Die erste Belichtungseinheit und/oder die mindestens eine weitere Belichtungseinheit sind bevorzugt eingerichtet, elektromagnetische Strahlung zu erzeugen, wobei die Wellenlänge bevorzugt im Bereich von 200 nm bis 2000 nm liegt. Besonders bevorzugt ist die elektromagnetische Strahlung schmalbandig oder monochromatisch, wobei eine Wellenlänge von 350 nm, 365 nm, 370 nm, 375 nm, 385 nm, 395 nm, 400 nm, 405 nm, 532 nm, 830 nm, 1064 nm einzeln oder eine Kombination mindestens zweier dieser Wellenlängen bevorzugt ist.

Bevorzugt umfassen die erste Belichtungseinheit und/oder die mindestens eine weitere Belichtungseinheit ein Segment oder mehrere Segmente, wobei ein Segment mindestens eine Lichtquelle ausgewählt aus der Gruppe bestehend aus Hochdrucklampen, Blitzlichtlampen, Niederdrucklampen, Fluoreszenzlampen, Lasern, lichtemittierende Dioden (LED) und Kombinationen hieraus umfasst.

Bei Verwendung von LEDs sind diese bevorzugt in Form von LED-Leisten oder LED-Arrays angeordnet. Bevorzugt umfasst die erste Belichtungseinheit LEDs. Gegebenenfalls vorhandene weitere Belichtungseinheiten können dann andere, nicht auf LEDs basierende Lichtquellen einsetzen. Dies ermöglicht es, beide Seiten des plattenförmigen Materials unter Verwendung von LEDs als Lichtquelle zu belichten, ohne dass eine zweite Belichtungseinheit mit LEDs vorgesehen werden muss. Bevorzugt sind die Lichtquellen der weiteren Belichtungseinheiten von LED verschiedene Lichtquellen.

In Belichtungsvorrichtungen gemäß dem Stand der Technik werden die teureren UV-LEDs insbesondere für das Belichten der Vorderseite eines plattenförmigen Materials eingesetzt. Das Belichten der Rückseite mit UV-LEDs ist aufgrund der Möglichkeit, einen gleichmäßigen, flachen, wenig strukturierten Floor zu erzeugen ebenfalls wünschenswert. Der Floor bezeichnet einen Bereich der Druckform ohne druckende Strukturen. Vorteilhafterweise erlaubt die erfindungsgemäße Belichtungsvorrichtung auch ein Belichten der Rückseite eines plattenförmigen Materials unter Verwendung von UV-LEDs, ohne dass eine weitere mit UV-LEDs ausgerüstete Belichtungseinheit angeordnet werden muss. Dies reduziert die Kosten und führt zu einem einfacheren und kompakteren Aufbau der Belichtungsvorrichtung.

In einer Ausführungsvariante sind die Segmente einer Belichtungseinheit alle gleichartig ausgestaltet, so dass diese elektromagnetische Strahlung gleicher Intensität und Wellenlänge erzeugen. In einer alternativen Ausführungsvariante sind unterschiedlich ausgestaltete Segmente vorgesehen, die sich in im Spektrum der emittierten elektromagnetischen Strahlung und/oder in der Intensität der emittierten Strahlung unterscheiden. Die Spektren einzelne Segmente können sich beispielsweise in der Wellenlänge der emittierten Strahlung unterscheiden. Des Weiteren können die Segmente jeweils breitbandige Strahlung, schmalbandige Strahlung oder monochromatische Strahlung erzeugen. Unter breitbandiger Strahlung wird hier insbesondere verstanden, dass das Segment elektromagnetische Strahlung mit einer Bandbreite von 30 nm oder mehr emittiert. Unter schmalbandiger Strahlung wird verstanden, dass die Brandbreite kleiner als 30 nm ist. Unter monochromatische Strahlung wird verstanden, dass das Spektrum von einer einzigen Wellenlänge dominiert ist.

Bevorzugt werden zur Belichtung alle Segmente der ersten Belichtungseinheit und/oder der mindestens einen weiteren Belichtungseinheit eingesetzt. Alternativ ist es bevorzugt, je nach Anforderung an das für die Belichtung benötigte Spektrum und/oder die für die Belichtung benötigte Intensität ein oder mehrere Segmente der jeweiligen Belichtungseinheit für die Belichtung auszuwählen.

Ist zusätzlich zu der ersten Belichtungseinheit auch mindestens eine weitere Belichtungseinheit vorgesehen, so sind die Belichtungseinheiten bevorzugt derart ausgestaltet, dass diese unabhängig voneinander ansteuerbar und betreibbar sind. Insbesondere ist es bevorzugt, dass die Belichtungseinheiten jeweils einzeln betreibbar sind, alternierend betreibbar sind und/oder alle Belichtungseinheiten gleichzeitig betreibbar sind. Dabei sind die Belichtungseinheiten bevorzugt derart ausgestaltet, dass über die Ansteuerung für jede Belichtungseinheit getrennt die verwendeten Segmente ausgewählt werden können sowie die Intensität und/oder das Spektrum steuerbar sind.

Durch die gezielte Auswahl der für die Belichtung verwendeten Segmente kann beispielsweise eine Anpassung des Belichtungsvorgangs an unterschiedliche Formate von plattenförmigen Materialien vorgenommen werden. Des Weiteren erlaubt die Steuerbarkeit der Intensität und Wellenlänge eine Anpassung der Belichtung an die für die bearbeiteten plattenförmigen Materialien bestehenden Erfordernisse.

Der Abstand zwischen der Oberfläche des plattenförmigen Materials und einer Belichtungseinheit beträgt üblicherweise im Bereich von 2 mm bis 100 mm, bevorzugt 2 mm bis 20 mm und beispielsweise 2 mm bis 10 mm. Die Strahlung von UV-LEDs weist praktisch keinen IR-Anteil auf, so dass auch eine hohe Intensität bei einem geringen Abstand zum Flexodruckelement möglich ist, ohne dass eine zu hohe Wärmebelastung des Flexodruckelements zu befürchten ist. Bevorzugt sind die erste Belichtungseinheit und/oder die mindestens eine weitere Belichtungseinheit derart eingerichtet, dass deren Abstand zu den zu belichtenden plattenförmigen Materialien variabel einstellbar ist. Hierzu wird die jeweilige Belichtungseinheit über eine Halterung so in der Belichtungsvorrichtung angeordnet, dass eine Translationsbewegung senkrecht zur Ebene des plattenförmigen Materials ermöglicht wird. Bevorzugt ermöglicht die Halterung eine Translationsbewegung im Bereich von 1 mm bis 100 mm.

Ist mindestens eine weitere Belichtungseinheit vorgesehen, so ist bevorzugt eine weitere Belichtungseinheit derart in Richtung der Trommel oder des Endlostransportbands weisend angeordnet, dass die mindestens eine weitere Belichtungseinheit für eine Belichtung von auf der Trommel oder des Endlostransportbands angeordneten plattenförmigen Materialien eingerichtet ist. Bevorzugt ist mehr als eine weitere Belichtungseinheit auf die Trommel oder des Endlostransportbands weisend angeordnet, beispielsweise von 2 bis 10 weitere Belichtungseinheiten. Diese sind bevorzugt so um die Trommel herum verteilt angeordnet und jeweils so auf die Rotationsachse der Trommel ausgerichtet, dass durch die Vielzahl von weiteren Belichtungseinheiten ein auf der Trommel angeordnetes plattenförmiges Material bei ruhender Trommel vollständig belichtet werden kann.

Bevorzugt ist die mindestens eine weitere Belichtungseinheit, als eine ringförmige Anordnung ausgestaltet, welche entlang der Rotationsachse der Trommel verschiebbar ist, wobei die ringförmige Anordnung auf die Oberfläche der Trommel gerichtete Lichtquellen umfasst. Diese Lichtquellen können insbesondere als LEDs ausgestaltet sein. Durch eine solche ringförmige Belichtungseinheit wird ein ringförmiger Bereich der Oberfläche der Trommel belichtet und entsprechend ein Ausschnitt des auf der Trommel angeordneten plattenförmigen Materials belichtet. Zum Belichten der gesamten Oberfläche des plattenförmigen Materials wird die ringförmige Belichtungseinheit entlang der Rotationsachse der Trommel verschoben, wobei die Trommel dabei ruht oder rotiert. Vorzugsweise rotiert die Trommel, wenn die ringförmige Belichtungseinheit entlang der Rotationsachse der Trommel verschoben wird.

Bevorzugt ist eine weitere Belichtungseinheit derart angeordnet, dass diese für eine der Positionen der ersten Belichtungseinheit der ersten Belichtungseinheit gegenübersteht. Dabei ist bevorzugt vorgesehen, dass das plattenförmige Material durch die Transportvorrichtung zwischen der ersten Belichtungseinheit und dieser weiteren Belichtungseinheit hindurchtransportiert wird. Hierdurch wird eine gleichzeitige Belichtung sowohl der ersten Seite als auch der zweiten Seite des plattenförmigen Materials ermöglicht.

Bevorzugt umfasst die Belichtungsvorrichtung zusätzlich eine Bebilderungseinheit. Diese kann beispielsweise als Lasersystem oder als Ink-Jet Drucksystem ausgestaltet sein. Bei Ausgestaltung als Lasersystem können als ablatierbare Maskenschicht, welche für UV-Strahlung undurchsichtig ist, ausgestaltete Schichten des plattenförmigen Materials selektiv entfernt werden und so eine Maske erstellt werden. Bei Ausgestaltung als Ink-Jet Drucksystem kann ein für UV-Strahlung intransparentes Material selektiv auf das plattenförmige Material aufgetragen und hierdurch eine Maske erstellt werden.

Die Bebilderungseinheit ist bevorzugt derart gegenüber der Trommel platziert und auf die Trommel weisend angeordnet, dass ein Schreiben einer Maske auf dem auf der Trommel aufgenommenen plattenförmigen Materials erfolgen kann.

Die Belichtungsvorrichtung umfasst bevorzugt eine Kontrolleinheit zur Steuerung der ersten Belichtungseinheit, der gegebenenfalls vorhandenen weiteren Belichtungseinheiten und der Transporteinheit. Bevorzugt ist die Kontrolleinheit des Weiteren eingerichtet, eine gegebenenfalls vorhandene Bebilderungseinheit zu steuern. Bevorzugt steht die Kontrolleinheit mit weiteren Vorrichtungen in Verbindung, die im Zusammenhang mit der Belichtungsvorrichtung zur Herstellung einer Druckform eingesetzt werden. Dabei wird insbesondere der Transport der plattenförmigen Materialien zwischen den einzelnen Vorrichtungen koordiniert. Bei den weiteren Vorrichtungen kann es sich insbesondere um Bildgebungsvorrichtungen, Wascher, Entwickler, UV-Nachbelichtungsvorrichtung und Trockner handeln. Ebenfalls steht die Kontrolleinheit bevorzugt mit einer Lagerverwaltung in Verbindung, so dass die plattenförmigen Materialien je nach Bedarf aus einer Lagereinrichtung entnommen, bearbeitet und wieder in eine Lagereinrichtung eingegeben werden können.

Die Kontrolleinheit steuert insbesondere die einzelnen durch die Belichtungsvorrichtung ausgeführten Belichtungsvorgänge der ersten Seite und/oder der zweiten Seite des plattenförmigen Materials, wobei für jede zu belichtende Seite und/oder für jede verwendete Belichtungseinheit andere Parameter gewählt werden können. Dabei kann auch vorgesehen sein, auf die Belichtung einer der Seiten des plattenförmigen Materials zu verzichten. Die Kontrolleinheit kann auch alle anderen Vorgänge steuern und überwachen, die im Zusammenhang mit der Verarbeitung des plattenförmiges Materials in Verbindung stehen, wobei einzelne Parameter und Vorgänge auch ausgenommen sein können. Bei den Parametern handelt es sich im Allgemeinen um Belichtungszeit Belichtungsintensität, Wellenlänge, Belichtungsfrequenz und Häufigkeit, Transportgeschwindigkeit, Rotationsgeschwindigkeit der Trommel, Position der ersten Belichtungseinheit, Abstand der Belichtungseinheit von der Plattenoberfläche, Temperatur, Art des Inertgases und/oder dessen Konzentration, Format des plattenförmigen Materials (Dicke, Länge, Breite, Material). Weiterhin steht die Kontrolleinheit bevorzugt in Verbindung mit Sensoren die den Zustand der Vorrichtung und/oder des plattenförmigen Materials überwachen, wie beispielsweise Ultraschall-, Temperatur-, Intensitäts-, Bewegungs-, Gas-, Positions-, Frequenz-, Geschwindigkeits-, Sensoren und beliebige Kombinationen. Die Kontrolleinheit kommuniziert bevorzugt auch mit anderen Geräten.

Die Belichtungsvorrichtung ist bevorzugt eingerichtet, mindestens einen Belichtungsvorgang unter Schutz durch ein Inertgas auszuführen. Hierzu ist zumindest ein Teilbereich der Belichtungsvorrichtung eingerichtet, das plattenförmige Material einem Inertgas auszusetzen, während das plattenförmige Material durch die erste Belichtungseinheit und/oder durch mindestens eine weitere Belichtungseinheit belichtet wird. Der Teilbereich kann von der Umgebung abgeschlossen sein und/oder es ist eine Inertgaszufuhr in dem Teilbereich angeordnet. Bei dem Inertgas kann es sich insbesondere um Stickstoff, Kohlendioxid oder um ein Edelgas wie beispielsweise Argon handeln.

Die Belichtungsvorrichtung ist bevorzugt eingerichtet, das plattenförmige Material und/oder die erste Belichtungseinheit sowie gegebenenfalls die mindestens eine weiteren Belichtungseinheit zu temperieren. Hierzu kann die Belichtungsvorrichtung mindestens eine Temperiereinrichtung umfassen, die beispielsweise als Infrarotstrahler, temperierte Walze, Heißluftzufuhr oder Kühleinrichtung ausgeführt ist. Bevorzugt wird das plattenförmige Material vor der Durchführung eines Belichtungsvorgangs auf eine vorgegebene Temperatur temperiert. Hierzu ist es bevorzugt, mindestens eine Temperiervorrichtung, in Transportrichtung des plattenförmigen Materials gesehen, vor der entsprechenden Belichtungseinheit anzuordnen.

Die Belichtungsvorrichtung umfasst bevorzugt des Weiteren eine Übergabeeinheit, die für die Übergabe des plattenförmigen Materials an eine weitere Vorrichtung eingerichtet ist. Die Übergabeeinheit kann beispielsweise als Greifer oder als ein verfahrbarer Tisch ausgestaltet sein.

Ein weiterer Aspekt der Erfindung ist es, eine Vorrichtung zur Herstellung von Druckformen aus einem plattenförmigen Material bereitzustellen, welche eine der beschriebenen Belichtungsvorrichtung zur Belichtung einer ersten Seite und einer zweiten Seite des plattenförmigen Materials, einen Wascher und einen Trockner und/oder einen Entwickler umfasst.

Eine derartige Vorrichtung umfasst neben der Belichtungsvorrichtung weitere Vorrichtungen, welche zur Herstellung von Druckformen aus einem plattenförmigen Material erforderlich sind. Der Wascher und/oder Entwickler sowie der Trockner sind dabei der Belichtungsvorrichtung nachgeschaltet.

Der Wascher dient zum Auswaschen von nicht belichteten Bereichen einer reliefbildenden Schicht des plattenförmigen Materials mittels eines Lösungsmittels und/oder Wasser bzw. wässrigen Lösungen. Hierzu werden Auswaschgeräte wie z.B. Bürstenwascher verwendet. Alternativ zum Auswaschen kann eine thermische Entwicklung erfolgen. Zum thermischen Entwickeln können Entwickler verwendet werden, bei denen ein Entwicklungsmedium mit dem verflüssigten unbelichteten Material in Kontakt gebracht und entfernt wird.

Bei Verwendung von Lösemitteln und/oder Wasser bzw. wässrigen Lösungen zum Auswaschen nicht belichteter Teile einer reliefbildenden Schicht des plattenförmigen Materials schließt sich eine Trocknung in einem nachgeschalteten Trockner an.

Insbesondere dann, wenn die in der Vorrichtung eingesetzte Belichtungsvorrichtung keine Bebilderungseinheit aufweist, umfasst die Vorrichtung bevorzugt eine Bebilderungsvorrichtung, welche der Belichtungsvorrichtung vorangestellt ist. In einer bevorzugten Ausführungsform ist die Bebilderungsvorrichtung zur Bebilderung von laserablatierbaren Maskenschichten eingerichtet.

Üblicherweise wird die Oberfläche der erhaltenen Druckform nach dem Trocknen nachbehandelt, beispielsweise durch Belichten der Oberfläche mit UVA- und/oder UVC-Strahlung. Hierfür umfasst die Vorrichtung bevorzugt eine dem Trockner nachgeschaltete Nachbelichtungsvorrichtung. Es ist jedoch auch möglich die Nachbelichtung in der beschriebenen Belichtungsvorrichtung durchzuführen.

Ein weiterer Aspekt der Erfindung ist es, ein Verfahren zur Belichtung von plattenförmigen Materialien bereitzustellen. Die beschriebene Belichtungsvorrichtung ist zur Durchführung der hierin beschriebenen Verfahren ausgebildet und/oder eingerichtet. Dementsprechend werden im Rahmen des Verfahrens beschriebene Merkmale entsprechend für die Belichtungsvorrichtung und umgekehrt die im Rahmen der Belichtungsvorrichtung beschriebenen Merkmale entsprechend für die Verfahren offenbart.

Das vorgeschlagene Verfahren zur Belichtung von plattenförmigen Materialien umfasst die Schritte
a) Bereitstellen eines plattenförmigen Materials,
b) Eingeben des plattenförmigen Materials in eine der beschriebenen Belichtungsvorrichtungen,
c) Transportieren des plattenförmigen Materials, so dass eine erste Seite des plattenförmigen Materials einer ersten Belichtungseinheit zugeführt wird und die erste Seite an der ersten Belichtungseinheit vorbeibewegt und durch die erste Belichtungseinheit belichtet wird, wobei die erste Belichtungseinheit um eine Achse drehbar ist und sich in einer ersten Position befindet,
d) Transportieren des plattenförmigen Materials, so dass eine zweite Seite des plattenförmigen Materials der ersten Belichtungseinheit zugeführt wird und die zweite Seite an der ersten Belichtungseinheit vorbeibewegt und durch die erste Belichtungseinheit belichtet wird, wobei sich die um eine Achse drehbare erste Belichtungseinheit in einer zweiten Position befindet, e) Entnehmen des plattenförmigen Materials aus der Belichtungsvorrichtung.

Insbesondere die Schritte des Eingebens des plattenförmigen Materials b) sowie das Entnehmen des plattenförmigen Materials gemäß Schritt e) können jeweils zumindest teilweise gleichzeitig bzw. parallel zu einem der Schritte c) oder d) ausgeführt werden, bei denen das plattenförmige Material transportiert und belichtet wird. Somit kann ein Transport und eine Belichtung bereits begonnen werden, bevor das plattenförmige Material gemäß Schritt b) vollständig in die Vorrichtung eingeführt wurde und entsprechend kann noch ein Schritt des Transportierens und Belichtens ausgeführt werden, während bereits Teile des plattenförmigen Materials gemäß Schritt e) aus der Belichtungsvorrichtung entnommen werden.

Das plattenförmige Material kann gemäß Schritt a) des Verfahrens aus einem Lager bereitgestellt werden oder jeweils einzeln zugeführt werden. Alternativ wird das plattenförmige Material aus einer vor der Belichtungsvorrichtung angeordneten weiteren Behandlungsvorrichtung entnommen, beispielsweise aus einer Bebilderungsvorrichtung zur Erzeugung einer Maske.

Die Schritte c) und d) des Verfahrens können in beliebiger Reihenfolge ausgeführt werden, wobei zwischen den Schritten die erste Belichtungseinheit von einer Position in die entsprechende andere Position bewegt wird. Bei einem Wechsel von Schritt c) zu Schritt d) wird die erste Belichtungseinheit von der ersten Position in die zweite Position bewegt und umgekehrt bei einem Wechsel von Schritt d) zu Schritt c) wird die erste Belichtungseinheit von der zweiten Position in die erste Position bewegt.

Die Transportgeschwindigkeit des plattenförmigen Materials ist bevorzugt im Bereich von 1mm/min bis 10000 mm/min gewählt. Dabei können für verschiedene Teilbereiche der Belichtungseinheit und entsprechend für die Ausführung der verschiedenen Schritte des Verfahrens jeweils unterschiedliche Transportgeschwindigkeiten gewählt werden,

Bevorzugt wird in Schritt d) das plattenförmige Material unter Verwendung einer Trommel und/oder eines Endlostransportbands transportiert, wobei die erste Belichtungseinheit in der zweiten Position der Trommel oder dem Endlostransportband zugewandt ist.

Bevorzugt verfügt die Trommel über zumindest eine Befestigungsvorrichtung. Dabei wird in Schritt d) des Verfahrens das plattenförmige Material zuerst auf der Trommel befestigt und durch Rotation der Trommel der ersten Belichtungseinheit in deren zweiter Position zugeführt. Nach dem Durchführen der Belichtung wird das plattenförmige Material wieder von der Trommel gelöst.

Bevorzugt wird die Rotationsgeschwindigkeit der Trommel so gewählt, dass diese im Bereich von 0,1 bis 5000 Umdrehung pro Minute liegt.

Bevorzugt wird durch Rotieren der Trommel das plattenförmige Material mindestens einmal an der ersten Belichtungseinheit vorbeigeführt und durch diese belichtet. In weiteren Varianten des Verfahrens kann vorgesehen sein, durch mehrmaliges Rotieren der Trommel das plattenförmige Material mehrfach an der ersten Belichtungseinheit vorbeizuführen und entsprechend mehrfach zu belichten. Beispielsweise können im Bereich von 2 bis 1000 Belichtungen durch eine entsprechende Anzahl von Rotationen der Trommel vorgenommen werden. Je nach Durchmesser der Trommel kann vorgesehen sein, dass jeweils nur ein plattenförmiges Material zur gleichen Zeit auf der Trommel aufgenommen ist. Bei entsprechendem Durchmesser der Trommel und entsprechendem Format des plattenförmigen Materials können zur gleichen Zeit auch mehr als ein plattenförmiges Material auf der Trommel angeordnet sein.

In der Zeit, in der das plattenförmige Material auf der Trommel aufgenommen ist, kann vorgesehen sein, eine Maske auf dem plattenförmigen Material zu erzeugen. Hierzu kann eine Bebilderungseinheit verwendet werden, die beispielsweise als Ablationslaser ausgeführt ist und selektiv eine ablatierbare Maskenschicht entfernt.

Bevorzugt erfolgt eine Belichtung der zweiten Seite unter Verwendung mindestens einer weiteren Belichtungseinheit während das plattenförmige Material gemäß der Schritte c) und/oder d) transportiert wird.

Bevorzugt wird, während das plattenförmige Material durch die erste Belichtungseinheit belichtet wird, eine Belichtung der zweiten Seite unter Verwendung mindestens einer weiteren Belichtungseinheit durchgeführt.

Bevorzugt wird die zweite Seite des plattenförmigen Materials während des Transports gemäß Schritt c) und/oder d) unter Verwendung mindestens einer weiteren Belichtungseinheit belichtet. Erfolgt der Transport gemäß Schritt d) unter Verwendung einer Trommel, so ist besonders bevorzugt die mindestens eine weitere Belichtungseinheit so angeordnet, dass diese auf die Trommel weist. Während der Belichtung der zweiten Seite mit der mindestens einen weiteren Belichtungseinheit kann die Trommel rotieren oder ruhen. Im Fall der Belichtung bei ruhender Trommel ist es bevorzugt, mehrere weitere Belichtungseinheiten so verteilt um die Trommel herum anzuordnen, dass die gesamte Fläche des plattenförmigen Materials gleichmäßig mit Strahlung durch die weiteren Belichtungseinheiten beaufschlagt wird. Durch die Trommel wird dann das plattenförmige Material so positioniert, dass eine Belichtung bei ruhender Trommel möglich ist. Anschließend wird die Belichtung bei ruhender Trommel ausgeführt. Nach dem Belichten wird das plattenförmige Material durch die Trommel weitertransportiert.

Zusätzlich zu den gemäß den Schritten c) oder d) durchgeführten Belichtungen kann eine weitere Belichtung unter Verwendung mindestens einer weiteren Belichtungseinheit erfolgen. Bei Ausführung des Schritts c) vor Schritt d) ist die weitere Belichtung dem Schritt d) nachgeschaltet. Bei Ausführung des Schritts c) nach Schritt d) erfolgt die weitere Belichtung vor der Ausführung des Schritts d). Hierbei kann durch entsprechende Anordnung der mindestens einen weiteren Belichtungseinheit eine Belichtung der ersten Seite und/oder der zweiten Seite des plattenförmigen Materials erfolgen.

Die bei den jeweiligen Belichtungen der Schritte c) und/oder d) sowie gegebenenfalls bei der weiteren Belichtung verwendete Intensität liegt bevorzugt im Bereich von 0,1 mW/cm² und 10 W/cm². Dabei ist die Dosis der Bestrahlung, die durch die Intensität und eine Einwirkzeit gegeben ist, so gewählt, dass die Bestrahlung mit der elektromagnetischen Strahlung ausreichend ist, ein auf dem plattenförmigen Material angeordnetes reliefbildendes Material zu härten. Das Härten erfolgt beispielsweise durch Vernetzen oder Polymerisieren von in dem reliefbildenden Material enthaltenen reaktiven Monomeren.

Die Belichtungsbedingungen, insbesondere die Wellenlänge, die Intensität, die Transportgeschwindigkeit und/oder des Endlostransportbands und/oder die Rotationsgeschwindigkeit der Trommel, können so gewählt sein, dass nach dem Auswaschen und/oder Entwickeln und Trocknung runde Druckpunkte oder runde und flache oder flache Druckpunkte entstehen.

Das plattenförmigen Material ist bevorzugt eine Druckplatte umfassend eine dimensionsstabile Trägerschicht und mindestens eine reliefbildende Schicht auf. Das reliefbildenden Material auf ist bevorzugt photoaktiv, also durch Einwirkung von elektromagnetischer Strahlung härtbar oder vernetzbar. Zusätzlich können weitere Schichten vorgesehen sein, beispielsweise mindestens eine Schutzschicht, mindestens eine Barriereschicht und/oder mindestens eine Maskenschicht. Auch Kombinationen mehrerer der genannten Schichten sind möglich.

Die in den Schritten c) und/oder d) sowie gegebenenfalls bei der weiteren Belichtung ausgeführten Belichtungen erfolgen bevorzugt in einer inerten Atmosphäre.

Kurze Beschreibung der Figuren
Figur 1 zeigt schematisch eine erste Ausführungsform der Belichtungsvorrichtung,
Figur 2 zeigt schematisch eine zweite Ausführungsform der Belichtungsvorrichtung,
Figur 3 zeigt schematisch eine dritte Ausführungsform der Belichtungsvorrichtung,
Figur 4 zeigt schematisch eine vierte Ausführungsform der Belichtungsvorrichtung und
Figur 5 zeigt schematisch eine fünfte Ausführungsform der Belichtungsvorrichtung, welche mindestens eine weitere Belichtungseinheit umfasst.

Die Erfindung und das erfindungsgemäße Verfahren werden in den nachstehenden Ausführungsbeispielen erläutert. In der Beschreibung der Ausführungsbeispiele der Erfindung werden gleiche oder ähnliche Komponenten und Elemente mit gleichen Bezugszeichen bezeichnet, wobei auf eine wiederholte Beschreibung dieser Komponenten oder Elemente in Einzelfällen verzichtet wird. Die Figuren stellen den Gegenstand der Erfindung nur schematisch dar.

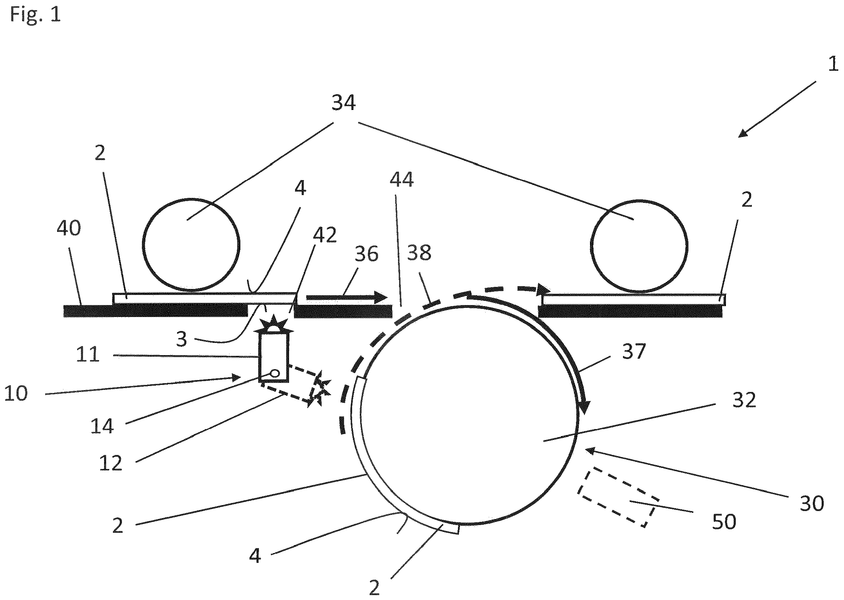

Figur 1 zeigt eine erste Ausführungsform einer Belichtungsvorrichtung 1 in einer schematischen Darstellung. Die Belichtungsvorrichtung 1 umfasst eine erste Belichtungseinheit 10 und eine Transporteinheit 30. Die Transporteinheit 30 umfasst eine Trommel 32, welche plattenförmiges Material 2, beispielsweise ein Druckelement, transportiert. In einer alternativen Ausführungsform kann anstelle der Trommel 32 ein Endlostransportband vorgesehen sein. Optional kann die Transporteinheit 30 noch weitere Elemente umfassen. In dem in der Figur 1 dargestellten Ausführungsbeispiel sind zusätzlich zu der Trommel 32 eine Ablage 40 und Transportwalzen 34 vorgesehen. Die Ablage 40 kann in weiteren Ausführungsvarianten auch als ein Transportband ausgestaltet werden. In der in Figur 1 dargestellten Ausführungsform ist die Ablage 40 aus mehreren Teileinheiten zusammengesetzt und an zwei Bereichen 42 und 44 unterbrochen.

Das plattenförmige Material 2 umfasst eine erste Seite 3, die in der Ausführungsform 1 die Unterseite des plattenförmigen Materials 2 darstellt, und eine zweite Seite 4, welche in dem dargestellten Ausführungsbeispiel die Oberseite des plattenförmigen Materials 2 darstellt.

Die erste Belichtungseinheit 10 ist als eine UV-Lichtquelle ausgestaltet, beispielsweise als eine LED-Leiste mit einer Vielzahl von UV-LEDs. Des Weiteren ist die erste Belichtungseinheit 10 drehbar ausgeführt, so dass diese um eine Drehachse 14 drehbar ist. Durch Drehen der ersten Belichtungseinheit 10 um die Drehachse 14 kann die erste Belichtungseinheit 10 mehrere Positionen einnehmen, wobei die erste Belichtungseinheit 10 zumindest eine erste Position 11 und eine zweite Position 12 einnehmen kann. In der in Figur 1 dargestellten Ausführungsform ist die erste Belichtungseinheit 10 unterhalb der Ablage 40 bzw. des Transportbands angeordnet, wobei die Ablage 40 bzw. das Transportband in einem Bereich 42 unterbrochen ist, der direkt oberhalb der ersten Belichtungseinheit 10 liegt. Durch den unterbrochenen Bereich 42 der Ablage 40 bzw. des Transportbands ist die erste Seite 3 des plattenförmigen Materials 2, welche sonst auf der Ablage 40 bzw. dem Transportband aufliegt, von unten her zugänglich.

Die in Figur 1 gezeigte Belichtungsvorrichtung 1 ist eingerichtet, sowohl die erste Seite 3 als auch die zweite Seite 4 des plattenförmigen Materials 2 unter Verwendung der ersten Belichtungseinheit 10 zu belichten. Hierzu wird in einem ersten Schritt das plattenförmige Material 2 unter Verwendung der als Transportband ausgestalteten Ablage 40 und/oder einer der Transportwalzen 34 entlang der mit Bezugszeichen 36 markierten Richtung bewegt. Dabei wird das plattenförmige Material 2 an der ersten Belichtungseinheit 10 vorbeibewegt, während sich die erste Belichtungseinheit 10 in ihrer ersten Position 11 befindet. Die erste Belichtungseinheit 10 ist bevorzugt so ausgestaltet, dass diese eine rechteckige Fläche belichten kann, wobei eine Seite des Rechtecks breiter ist als die Breite des plattenförmige Material 2, so dass das plattenförmige Material 2 in dessen gesamter Breite auf einmal durch die erste Belichtungseinheit 10 belichtet wird. UV-Licht der ersten Belichtungseinheit 10 in der ersten Position 11 gelangt dabei durch den unterbrochenen Bereich 42 hindurch auf das plattenförmige Material 2.

Ist das plattenförmige Material 2 ein Flexodruckelement, so ist die erste Seite 3 bevorzugt die Rückseite des Flexodruckelements, so dass in dem ersten Schritt durch die Belichtungseinheit 10 in der ersten Position 11 eine Rückseitenbelichtung vorgenommen wird.

Die in Figur 1 dargestellte Vorrichtung 1 kann bei der Belichtung der ersten Seite 3 des plattenförmigen Materials 2 dieses kontinuierlich entlang der mit dem Pfeil 36 markierten Richtung transportieren. Alternativ hierzu kann der Transport diskontinuierlich erfolgen, wobei jeweils ein Teilbereich des plattenförmigen Materials 2 in den Sichtbereich der ersten Belichtungseinheit 10 transportiert wird, danach der Transport gestoppt wird, die Belichtung dieses Teilbereichs erfolgt und anschließend das plattenförmige Material 2 weitertransportiert wird, um den nächsten Teilbereich zu belichten.

In einem zweiten Schritt wird das plattenförmige Material 2 zu der Trommel 32 transportiert und auf der Trommel 32 aufgenommen, wobei das plattenförmige Material 2 wie mit dem Pfeil 37 angedeutet zusammen mit der Trommel 32 umläuft. Die Trommel 32 ist dabei so unterhalb der Ablage 40 bzw. des Transportbands angeordnet, dass das plattenförmige Material 2 durch eine weitere Unterbrechung 44 der Ablage 40 bzw. des Transportbands von oben auf die Trommel 32 aufgelegt und anschließend auf der Trommel 32 aufgenommen wird. Bevorzugt umfasst die Trommel 32 für das Aufnehmen des plattenförmigen Materials 2 mindestens eine Befestigungsvorrichtung, die beispielsweise als Vakuum-Saugbefestigung, mit Hilfe von Stanzlöchern, oder Stanzen oder Klemmen ausgestaltet ist. Hierzu sind auf der Oberfläche der Trommel 32 Öffnungen vorgesehen über die das plattenförmige Material 2 durch einen Unterdruck fixiert werden kann.

Die erste Belichtungseinheit 10 wird durch Drehen um die Drehachse 14 von der ersten Position 11 in ihre zweite Position 12 bewegt und weist nun auf die Trommel 32. Durch Drehen der Trommel 32 wird das plattenförmige Material 2 erneut an der ersten Belichtungseinheit 10 vorbeigeführt, wobei nun die zweite Seite 4 des plattenförmigen Materials 2 der ersten Belichtungseinheit 10 zugewandt ist und von der ersten Belichtungseinheit 10 belichtet wird. Wiederum ist es je nach Anforderung des ausgeführten Belichtungsprozesses möglich, das plattenförmige Material 2 kontinuierlich oder diskontinuierlich an der ersten Belichtungseinheit 10 in der zweiten Position 12 vorbeizuführen. Falls mehrere Belichtungen erforderlich sind, so können weitere Belichtungen mit weiteren Umdrehungen der Trommel 32 erfolgen. Nach der Belichtung der zweiten Seite 4 des plattenförmigen Materials 2 wird die erste Belichtungseinheit 10 wieder zurück in ihre erste Position 11 bewegt, so dass diese für eine Belichtung der ersten Seite 3 eines weiteren plattenförmigen Materials zur Verfügung steht.

Handelt es sich bei dem plattenförmigen Material 2 um ein Flexodruckelement, so ist die zweite Seite 4 bevorzugt die Vorderseite des Flexodruckelements.

In einer Ausführungsvariante der Belichtungsvorrichtung 1 kann vorgesehen sein, dass zusätzlich eine Bebilderungseinheit 50 zum Schreiben einer Maske auf dem plattenförmigen Material 2 vorgesehen ist. Die Bebilderungseinheit 50 weist in Richtung der Trommel 32, so dass die Maske geschrieben werden kann, während das plattenförmige Material 2 kontinuierlich oder diskontinuierlich durch Drehen der Trommel 32 an der Bebilderungseinheit 50 vorbeigeführt wird. Die Bebilderungseinheit 50 ist in Transportrichtung gesehen, vergleiche Pfeil 37, vor der ersten Belichtungseinheit 10 in der zweiten Position 12 angeordnet. Auf diese Weise wird die für eine bildmäßige Belichtung der zweiten Seite 4 verwendete Maske kurz vor der Belichtung durch die erste Belichtungseinheit 10 in der zweiten Position 12 erzeugt. Bei der Bebilderungseinheit 50 kann es sich beispielsweise um ein Lasersystem handeln, mit dem eine laserablatierbare Maskenschicht des plattenförmigen Materials 2 selektiv entfernt wird.

In einem dritten Schritt wird das plattenförmige Material 2 entlang der mit dem Pfeil 38 angedeuteten Richtung von der Trommel 32 gelöst. Wobei eine gegebenenfalls an der Trommel 32 vorhandene Befestigungsvorrichtung das plattenförmige Material 2 freigibt. Das plattenförmige Material 2 wird wieder auf die Ablage 40 bzw. das Transportband abgelegt und aus der Belichtungsvorrichtung 1 heraustransportiert. Im Anschluss kann das plattenförmige Material 2 in weiteren Vorrichtungen nachbehandelt werden. Ist die Belichtungsvorrichtung 1 Teil einer Gesamtvorrichtung zur Herstellung von Druckformen, so kann eine Übergabe an die nächste Behandlungsvorrichtung erfolgen, insbesondere kann das plattenförmige Material 2 an einen Entwickler oder an einen Wascher übergeben werden.

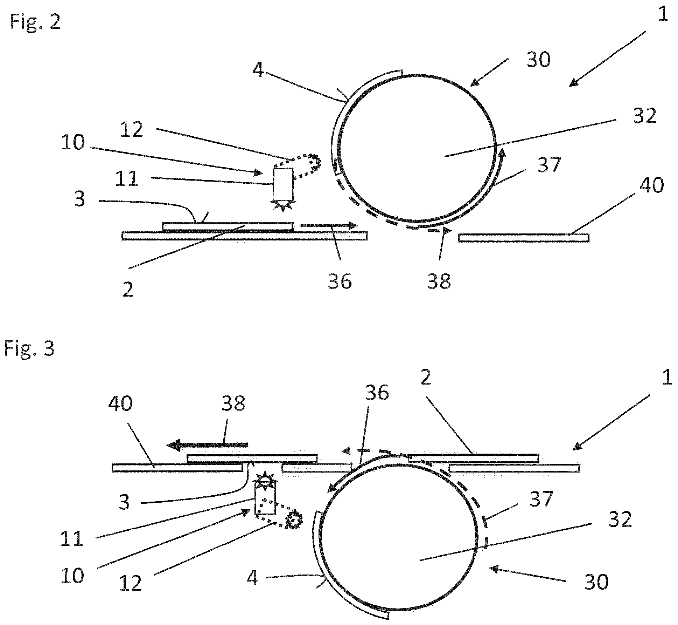

Figur 2 zeigt eine zweite Ausführungsform der Belichtungsvorrichtung 1, die wie die mit Bezug zur Figur 1 beschriebene erste Ausführungsform eine erste Belichtungseinheit 10 sowie eine Transporteinheit 30. Die Transporteinheit 30 umfasst eine Trommel 32. Zusätzlich umfasst die Transporteinheit 30 in der in Figur 2 dargestellten Ausführungsform eine als Transportband ausgestaltete Ablage 40 auf. Im Gegensatz zu der ersten Ausführungsform sind sowohl die erste Belichtungseinheit 10 als auch die Trommel 32 oberhalb der Ablage 40 bzw. des Transportbands angeordnet. Des Weiteren ist im Bereich der ersten Belichtungseinheit 10 keine Unterbrechung der Ablage 40 vorgesehen.

Zur beidseitigen Belichtung des plattenförmigen Materials 2 ist in einem ersten Schritt vorgesehen, das plattenförmige Material 2 entlang der mit dem Pfeil 36 angegebenen Richtung an der ersten Belichtungseinheit 10, welche sich in der ersten Position 11 befindet, vorbeizuführen. Dabei wird die erste Seite 3 des plattenförmigen Materials 2 belichtet. Wiederum kann die Belichtung kontinuierlich oder diskontinuierlich erfolgen. Da sich die erste Belichtungseinheit 10 oberhalb der Ablage 40 bzw. des Transportbands befindet, ist in dem Bereich der ersten Belichtungseinheit 10 keine Unterbrechung der Ablage 40 bzw. des Transportbands erforderlich, da keine Belichtung der auf dem Transportband 40 aufliegenden Seite des plattenförmigen Materials 2 erfolgt. Nach dem Belichten wird das plattenförmige Material 2 weiter entlang der durch den Pfeil 36 angedeuteten Richtung auf die Trommel 32 zubewegt.

Die Trommel 32 ist ebenfalls oberhalb der Ebene der Ablage 40 bzw. des Transportbands angeordnet, so dass das plattenförmige Material 2 an der Unterseite der Trommel 32 auf die Oberfläche der Trommel 32 trifft und auf der Oberfläche der Trommel 32 angeordnet wird. Das auf der Trommel 32 aufgenommene plattenförmige Material 2 läuft anschließend zusammen mit der sich drehenden Trommel 32 um. Die Umlaufbewegung ist mit dem Pfeil 37 angedeutet. Die erste Belichtungseinheit 10 wird in die zweite Position 12 bewegt, in der diese nun auf die Trommel 32 ausgerichtet ist. Während des Umlaufens der Trommel 32 wird das plattenförmige Material 2 mit dessen zweiter Seite 4 an der ersten Belichtungseinheit 10 in der zweiten Position 12 vorbeibewegt und belichtet. Wiederum kann dieser Belichtungsvorgang kontinuierlich oder diskontinuierlich erfolgen. Falls mehrere Belichtungen erforderlich sind, so können weitere Belichtungen mit weiteren Umdrehungen der Trommel 32 erfolgen. Optional kann, wie mit Bezug zu Figur 1 beschrieben, eine zusätzliche Bebilderungseinheit vorgesehen werden, die, während das plattenförmige Material 2 auf der Trommel 32 aufgenommen ist, vor dem Vorbeibewegen an der ersten Belichtungseinheit 10 in der zweiten Position 12 eine Maske in das plattenförmige Material 2 schreibt.

In einem dritten Schritt wird das plattenförmige Material 2 entlang der mit dem Pfeil 38 angedeuteten Richtung von der Trommel 32 gelöst, wobei eine gegebenenfalls an der Trommel 32 vorhandene Befestigungsvorrichtung das plattenförmige Material 2 freigibt. Das plattenförmige Material 2 wird wieder auf die Ablage 40 bzw. das Transportband abgelegt und aus der Belichtungsvorrichtung 1 heraustransportiert. Im Anschluss kann das plattenförmige Material in weiteren Vorrichtungen nachbehandelt werden. Ist die Belichtungsvorrichtung 1 Teil einer Gesamtvorrichtung zur Herstellung von Druckformen, so kann eine Übergabe an die nächste Behandlungsvorrichtung erfolgen, insbesondere kann das plattenförmige Material 2 an einen Entwickler oder an einen Wascher übergeben werden. Für die Übergabe kann die Belichtungsvorrichtung zusätzlich eine Übergabeeinheit mit entsprechenden Transportmitteln umfassen.

In der Figur 3 wird eine dritte Ausführungsform der Belichtungsvorrichtung 1 gezeigt. Diese entspricht in ihrem Aufbau der mit Bezug zur Figur 1 beschriebenen ersten Ausführungsform, jedoch durchläuft das plattenförmige Material 2 die Belichtungsvorrichtung 1 in umgekehrter Richtung.

In einem ersten Schritt befindet sich die erste Belichtungseinheit 10 in ihrer zweiten Position 12 und das plattenförmige Material 2 wird über die Ablage 40 bzw. das Transportband entlang der mit dem Pfeil 36 angedeuteten Richtung von oben auf die Trommel 32 aufgelegt und anschließend auf der Trommel 32 aufgenommen, so dass das plattenförmige Material 2 mit der Trommel 32 umläuft. Während das plattenförmige Material 2 an der ersten Belichtungseinheit 10 in der zweiten Position 12 vorbeigeführt wird, wird durch die erste Belichtungseinheit 10 die zweite Seite 4 belichtet. Wiederum kann die Belichtung kontinuierlich oder diskontinuierlich erfolgen. Falls mehrere Belichtungen erforderlich sind, so können weitere Belichtungen mit weiteren Umdrehungen der Trommel 32 erfolgen.

In einem zweiten Schritt wird das plattenförmige Material 2 von der Trommel 32 gelöst und wie mit dem Pfeil mit Bezugszeichen 37 angedeutet auf die Ablage 40 bzw. das Transportband aufgelegt. Die erste Belichtungseinheit 10 wird in ihre erste Position 11 bewegt.

In einem dritten Schritt wird die erste Seite 3 des plattenförmigen Materials 3 durch einen unterbrochenen Bereich 42 von unten durch die erste Belichtungseinheit 10 in der ersten Position 11 belichtet. Das plattenförmige Material 2 wird dabei kontinuierlich oder diskontinuierlich, je nach Ausführung des Belichtungsvorgangs, entlang der mit dem Pfeil 38 markierten Richtung bewegt und anschließend aus der Belichtungsvorrichtung 1 heraustransportiert. Nach dem Belichten wird die erste Belichtungseinheit 10 wieder in die zweite Position 12 bewegt, so dass diese für eine weitere Belichtung der zweiten Seite eines weiteren plattenförmigen Materials bereitsteht.

Im Anschluss an die Belichtung der ersten Seite 3 kann das plattenförmige Material 2 in weiteren Vorrichtungen nachbehandelt werden. Ist die Belichtungsvorrichtung 1 Teil einer Gesamtvorrichtung zur Herstellung von Druckformen, so kann eine Übergabe an die nächste Behandlungsvorrichtung erfolgen, insbesondere kann das plattenförmige Material 2 an einen Entwickler oder an einen Wascher übergeben werden.

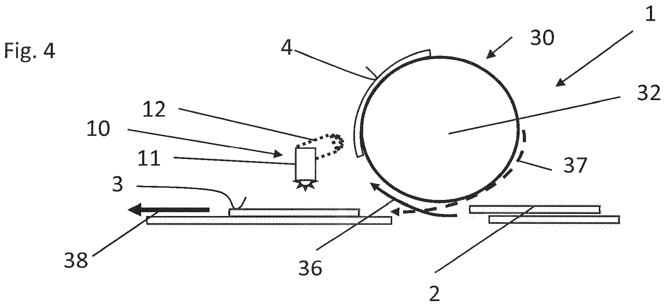

In der Figur 4 wird eine vierte Ausführungsform der Belichtungsvorrichtung 1 gezeigt. Diese entspricht in ihrem Aufbau der mit Bezug zur Figur 2 beschriebenen zweiten Ausführungsform, jedoch durchläuft das plattenförmige Material 2 die Belichtungsvorrichtung 1 in umgekehrter Richtung.

In einem ersten Schritt befindet sich die erste Belichtungseinheit 10 in ihrer zweiten Position 12 und das plattenförmige Material 2 wird über die Ablage 40 bzw. das Transportband entlang der mit dem Pfeil 36 angedeuteten Richtung von unten an die Trommel 32 herangeführt und anschließend auf der Trommel 32 aufgenommen, so dass das plattenförmige Material 2 mit der Trommel 32 umläuft. Während das plattenförmige Material 2 an der ersten Belichtungseinheit 10 in der zweiten Position 12 vorbeigeführt wird, wird durch die erste Belichtungseinheit 10 die zweite Seite 4 belichtet. Wiederum kann die Belichtung kontinuierlich oder diskontinuierlich erfolgen. Falls mehrere Belichtungen erforderlich sind, so können weitere Belichtungen mit weiteren Umdrehungen der Trommel 32 erfolgen.

In einem zweiten Schritt wird das plattenförmige Material 2 von der Trommel 32 gelöst und wie mit dem Pfeil mit Bezugszeichen 37 angedeutet auf die Ablage 40 bzw. das Transportband aufgelegt. Die erste Belichtungseinheit 10 wird in ihre erste Position 11 bewegt.

In einem dritten Schritt wird die erste Seite 3 des plattenförmigen Materials 3 von oben durch die erste Belichtungseinheit 10 in der ersten Position 11 belichtet. Das plattenförmige Material 2 wird dabei kontinuierlich oder diskontinuierlich, je nach Ausführung des Belichtungsvorgangs, entlang der mit dem Pfeil 38 markierten Richtung bewegt und anschließend aus der Belichtungsvorrichtung 1 heraustransportiert. Nach dem Belichten wird die erste Belichtungseinheit 10 wieder in die zweite Position 12 bewegt, so dass diese für eine weitere Belichtung der zweiten Seite eines weiteren plattenförmigen Materials bereitsteht.

Im Anschluss an die Belichtung der ersten Seite 3 kann das plattenförmige Material 2 in weiteren Vorrichtungen nachbehandelt werden. Ist die Belichtungsvorrichtung 1 Teil einer Gesamtvorrichtung zur Herstellung von Druckformen, so kann eine Übergabe an die nächste Behandlungsvorrichtung erfolgen, insbesondere kann das plattenförmige Material 2 an einen Entwickler oder an einen Wascher übergeben werden.

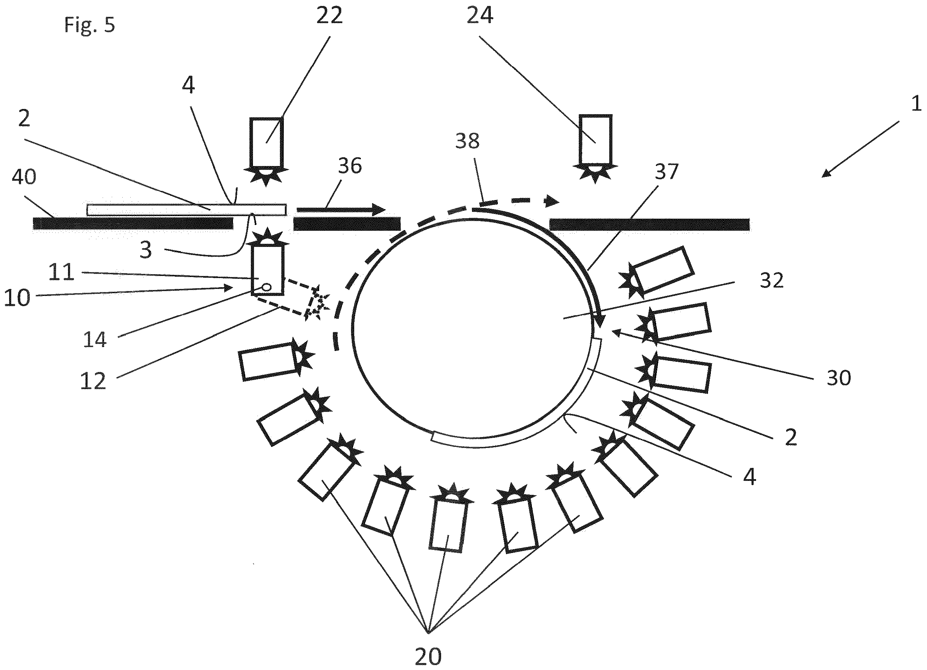

In der Figur 5 wird eine fünfte Ausführungsform der Belichtungsvorrichtung 1 gezeigt. Diese entspricht in ihrem Aufbau der mit Bezug zur Figur 1 beschriebenen ersten Ausführungsform, jedoch sind zusätzlich weitere Belichtungseinheiten 20, 22, 24 vorgesehen. Die weiteren Belichtungseinheiten 20, 22, 24 sind optional, so dass je nach Ausführungsvariante nur eine weitere Belichtungseinheit 20, 22, 24 oder nur einige der dargestellten weiteren Belichtungseinheiten 20, 22, 24 angeordnet werden.

Eine weitere Belichtungseinheit 22 ist gegenüber der ersten Belichtungseinheit 10 in der ersten Position 11 angeordnet, so dass diese die zweite Seite 4 des plattenförmigen Materials 2 belichten kann, während die erste Belichtungseinheit 10 in der ersten Position 11 die erste Seite 3 belichtet.

Weitere Belichtungseinheit 20 sind zudem um die Trommel 32 herum verteilt angeordnet, wobei die weiteren Belichtungseinheiten 20 jeweils auf die Trommel 32 weisen. Auf diese Weise ist durch die weiteren Belichtungseinheiten 20 eine Belichtung der zweiten Seite 4 des plattenförmigen Materials möglich, während dieses auf der Trommel 32 aufgenommen ist. Bevorzugt sind dabei mehrere weitere Belichtungseinheiten 20 so um die Trommel 32 verteilt angeordnet, dass auch bei ruhender Trommel 32 die gesamte Fläche der zweiten Seite 4 des plattenförmigen Materials 2 auf einmal belichtet werden kann.

Eine weitere Belichtungseinheit 24 ist in Transportrichtung 38 gesehen nach der Trommel 32 oberhalb der Ablage 40 bzw. des Transportbands angeordnet. Über die weitere Belichtungseinheit 24 kann eine weitere Belichtung der zweiten Seite 4 des plattenförmigen Materials 2 erfolgen, die einer Belichtung der zweiten Seite 4 durch die erste Belichtungseinheit 10 in der zweiten Position 12 nachgeschaltet ist.

Die weiteren Belichtungseinheiten 20, 22, 24 können selbstverständlich auch mit den mit Bezug zu den Figuren 2 bis 4 beschriebenen Ausführungsformen der Belichtungsvorrichtung kombiniert werden.

## Patentansprüche

1. Belichtungsvorrichtung (1) zur Belichtung von plattenförmigem Material (2) wobei das plattenförmige Material (2) eine erste Seite (3) und eine der ersten Seite (3) gegenüberliegende zweite Seite (4) aufweist und wobei die Belichtungsvorrichtung (1) eine erste Belichtungseinheit (10) und eine Transporteinheit (30) umfasst, **dadurch gekennzeichnet, dass** die erste Belichtungseinheit (10) mindestens ein Segment mit einer Lichtquelle umfasst und um eine Achse (14) drehbar ausgeführt ist, wobei die erste Belichtungseinheit (10) durch Drehen um die Achse (14) eine erste Position (11) und eine zweite Position (12) einnehmen kann und die erste Belichtungseinheit (10) sowie die Transporteinheit (30) derart eingerichtet sind, dass in der ersten Position (11) der ersten Belichtungseinheit (10) die erste Seite (3) des plattenförmigen Materials (2) für eine Belichtung zugeführt und an der ersten Belichtungseinheit (10) vorbeibewegt wird und in der zweiten Position (12) der ersten Belichtungseinheit (10) die zweite Seite (4) des plattenförmigen Materials (2) für eine Belichtung zugeführt und an der ersten Belichtungseinheit (10) verbeibewegt wird.

2. Belichtungsvorrichtung (1) nach Anspruch 1, **dadurch gekennzeichnet, dass** die Belichtungsvorrichtung (1) mindestens eine weitere Belichtungseinheit (20, 22, 24) umfasst.

3. Belichtungsvorrichtung (1) nach Anspruch 1 oder 2, **dadurch gekennzeichnet, dass** die erste Belichtungseinheit (10) und/oder die mindestens eine weitere Belichtungseinheit (20, 22, 24) eingerichtet ist eine streifenförmige Fläche des plattenförmigen Materials (2) zu belichten, wobei die lange Seite der streifenförmigen Fläche senkrecht zu einer Transportrichtung des plattenförmigen Materials (2) orientiert ist.

4. Belichtungsvorrichtung (1) nach einem der Ansprüche 1 bis 3, **dadurch gekennzeichnet, dass** die erste Belichtungseinheit (10) und/oder die mindestens eine weitere Belichtungseinheit (20, 22, 24) elektromagnetische Strahlung erzeugen, wobei die Wellenlänge bevorzugt im Bereich von 200 nm bis 2000 nm liegt und besonders bevorzugt die elektromagnetische Strahlung schmalbandig oder monochromatisch mit einer Wellenlänge von 350 nm, 360 nm, 365 nm, 370 nm, 375 nm, 385 nm, 395 nm, 400 nm, 405 nm, 532 nm, 830 nm, 1064 nm oder eine Kombinationen mindestens zweier dieser Wellenlängen ist.

5. Belichtungsvorrichtung (1) nach einem der Ansprüche 1 bis 4, **dadurch gekennzeichnet, dass** die erste Belichtungseinheit (10) und/oder die mindestens eine weitere Belichtungseinheit (20, 22, 24) ein Segment oder mehrere Segmente umfassen, wobei ein Segment mindestens eine Lichtquelle ausgewählt aus der Gruppe bestehend aus Hochdrucklampen, Blitzlichtlampen, Niederdrucklampen, Fluoreszenzlampen, Laser, lichtemittierende Dioden (LED) und Kombinationen hieraus umfasst.

6. Belichtungsvorrichtung (1) nach einem der Ansprüche 1 bis 5, **dadurch gekennzeichnet, dass** die Transporteinheit (30) eine rotierbare Trommel (32) umfasst, wobei die Drehachse (14) der ersten Belichtungseinheit (10) parallel zur Rotationsachse der Trommel (32) verläuft, oder dass die Transporteinheit (30) ein Endlostransportband umfasst, wobei die Drehachse (14) der ersten Belichtungseinheit (10) bevorzugt senkrecht zu einer Transportrichtung des Endlostransportbandes und parallel zu einer Ebene des Endlostransportbandes ausgerichtet ist.

7. Belichtungsvorrichtung (1) nach Anspruch 6, **dadurch gekennzeichnet, dass** die Transporteinheit (30) mindestens eine Befestigungsvorrichtung für plattenförmige Materialien (2) ausgewählt aus einer Befestigungsleiste, einer Klemmvorrichtung, einer Vakuum Saugbefestigung oder einer Kombination mehrerer Befestigungsvorrichtungen aufweist.

8. Belichtungsvorrichtung (1) nach Anspruch 6 oder 7, **dadurch gekennzeichnet, dass** die mindestens eine weitere Belichtungseinheit (20, 22, 24) derart in Richtung der Transporteinheit (30) weisend angeordnet ist, dass die mindestens eine weitere Belichtungseinheit (20, 22, 24) für eine Belichtung von auf der Transporteinheit (30) angeordneten plattenförmigen Materialien (2) eingerichtet ist.

9. Belichtungsvorrichtung (1) nach einem der Ansprüche 6 bis 8, **dadurch gekennzeichnet, dass** die mindestens eine weitere Belichtungseinheit (20, 22, 24) als eine ringförmige Anordnung ausgestaltet ist, welche entlang der Rotationsachse der Trommel (32) verschiebbar ist, wobei die ringförmige Anordnung auf die Oberfläche der Trommel (32) gerichtete Lichtquellen umfasst und/oder dass die mindestens eine weitere Belichtungseinheit (20, 22, 24) derart angeordnet ist, dass diese für eine der Positionen der ersten Belichtungseinheit (10) der ersten Belichtungseinheit (10) gegenübersteht.

10. Belichtungsvorrichtung (1) nach einem der Ansprüche 1 bis 9, **dadurch gekennzeichnet, dass** die Belichtungsvorrichtung (1) zusätzlich eine Bebilderungseinheit (50) umfasst.

11. Vorrichtung zur Herstellung von Druckformen aus einem plattenförmigen Material (2) umfassend
- eine Belichtungsvorrichtung (1) gemäß einem der Ansprüche 1 bis 10 zur Belichtung einer ersten Seite (3) und einer zweiten Seite (4) des plattenförmigen Materials (2),
- eine Wascheinheit und eine Trocknungseinheit oder eine Entwicklungseinheit.

12. Verfahren zur Belichtung von plattenförmigen Materialien (2) umfassend die Schritte
a) Bereitstellen eines plattenförmigen Materials (2),
b) Eingeben des plattenförmigen Materials in eine Belichtungsvorrichtung (1) gemäß einem der Ansprüche 1 bis 10,
c) Transportieren des plattenförmigen Materials (2), so dass eine erste Seite (3) des plattenförmigen Materials (2) einer ersten Belichtungseinheit (10) zugeführt wird und die erste Seite (3) an der ersten Belichtungseinheit (10) vorbeibewegt und durch die erste Belichtungseinheit (10) belichtet wird, wobei die erste Belichtungseinheit (10) um eine Achse (14) drehbar ist und sich in einer ersten Position (11) befindet,
d) Transportieren des plattenförmigen Materials (2), so dass eine zweite Seite (4) des plattenförmigen Materials (2) der ersten Belichtungseinheit (10) zugeführt wird und die zweite Seite (4) an der ersten Belichtungseinheit (10) vorbeibewegt und durch die erste Belichtungseinheit (10) belichtet wird, wobei sich die um eine Achse (14) drehbare erste Belichtungseinheit (10) in einer zweiten Position (12) befindet,
e) Entnehmen des plattenförmigen Materials (2) aus der Belichtungsvorrichtung (1),
wobei die Schritte c) und d) in beliebiger Reihenfolge ausgeführt werden können und die Schritte b) und e) jeweils zumindest teilweise parallel zu einem der Schritte c) und d) ausgeführt werden können.

13. Verfahren gemäß Anspruch 12, **dadurch gekennzeichnet, dass** in Schritt d) das plattenförmige Material (2) unter Verwendung einer Transporteinheit (30) bewegt wird, und die erste Belichtungseinheit (10) in der zweiten Position (12) der Transporteinheit (30) zugewandt ist.

14. Verfahren gemäß Anspruch 12 oder 13, **dadurch gekennzeichnet, dass**, während das plattenförmige Material (2) gemäß der Schritte c) und/oder d) transportiert wird, eine Belichtung der zweiten Seite (4) unter Verwendung mindestens einer weiteren Belichtungseinheit (20, 22, 24) erfolgt.

15. Verfahren gemäß einem der Ansprüche 12 bis 14, **dadurch gekennzeichnet, dass** während das plattenförmige Material (2) durch die erste Belichtungseinheit (10) belichtet wird, eine Belichtung der zweiten Seite unter Verwendung mindestens einer weiteren Belichtungseinheit (20, 22, 24) erfolgt.

## Claims

1. Exposure device (1) for exposing planar material (2), the planar material (2) having a first side (3) and a second side (4) opposite the first side (3) and the exposure device (1) having a first exposure unit (10) and a transport unit (30), **characterised in that** the first exposure unit (10) comprises at least one segment having a light source and is designed to be rotatable about a pin (14), the first exposure unit (10) being able to assume a first position (11) and a second position (12) by rotation about the pin (14) and the first exposure unit (10) and the transport unit (30) being configured such that in the first position (11) of the first exposure unit (10), the first side (3) of the planar material (2) is supplied and moved past the first exposure unit (10) for exposure, and in the second position (12) of the first exposure unit (10), the second side (4) of the planar material (2) is supplied and moved past the first exposure unit (10) for exposure.

2. Exposure device (1) according to claim 1, **characterised in that** the exposure device (1) comprises at least one further exposure unit (20, 22, 24).

3. Exposure device (1) according to either claim 1 or claim 2, **characterised in that** the first exposure unit (10) and/or the at least one further exposure unit (20, 22, 24) is configured to expose a strip-shaped surface of the planar material (2), the long side of the strip-shaped surface being oriented perpendicularly with respect to a transport direction of the planar material (2).

4. Exposure device (1) according to any of claims 1 to 3, **characterised in that** the first exposure unit (10) and/or the at least one further exposure unit (20, 22, 24) generate electromagnetic radiation, the wavelength being preferably in the range of from 200 nm to 2000 nm and the electromagnetic radiation particularly preferably being narrow-band or monochromatic having a wavelength of 350 nm, 360 nm, 365 nm, 370 nm, 375 nm, 385 nm, 395 nm, 400 nm, 405 nm, 532 nm, 830 nm, 1064 nm or a combination of at least two of these wavelengths.

5. Exposure device (1) according to any of claims 1 to 4, **characterised in that** the first exposure unit (10) and/or the at least one further exposure unit (20, 22, 24) comprise one or more segments, a segment having at least one light source selected from the group consisting of high-pressure lamps, flashlight lamps, low-pressure lamps, fluorescent lamps, lasers, light emitting diodes (LED), and combinations thereof.

6. Exposure device (1) according to any of claims 1 to 5, **characterised in that** the transport unit (30) comprises a rotatable drum (32), the swivel pin (14) of the first exposure unit (10) extending in parallel with the axis of rotation of the drum (32), or **in that** the transport unit (30) comprises a continuous conveyor belt, the swivel pin (14) of the first exposure unit (10) preferably being aligned perpendicularly with respect to a transport direction of the continuous conveyor belt and in parallel with a plane of the continuous conveyor belt.

7. Exposure device (1) according to claim 6, **characterised in that** the transport unit (30) has at least one fastening device for planar materials (2) selected from a fastening strip, a clamping device, a vacuum suction fastening, or a combination of several fastening devices.

8. Exposure device (1) according to either claim 6 or claim 7, **characterised in that** the at least one further exposure unit (20, 22, 24) is arranged facing the transport unit (30) such that the at least one further exposure unit (20, 22, 24) is configured for exposing planar materials (2) arranged on the transport unit (30).

9. Exposure device (1) according to any of claims 6 to 8, **characterised in that** the at least one further exposure unit (20, 22, 24) is designed as an annular arrangement which is displaceable along the axis of rotation of the drum (32), the annular arrangement comprising light sources directed onto the surface of the drum (32), and/or **in that** the at least one further exposure unit (20, 22, 24) is arranged such that it faces the first exposure unit (10) for one of the positions of the first exposure unit (10).

10. Exposure device (1) according to any of claims 1 to 9, **characterised in that** the exposure device (1) additionally comprises an imaging unit (50).

11. Device for producing printing plates from a planar material (2), said device comprising
- an exposure device (1) according to any of claims 1 to 10 for exposing a first side (3) and a second side (4) of the planar material (2),
- a washing unit and a drying unit or a developing unit.

12. Method for exposing planar materials (2), comprising the steps of
a) providing a planar material (2),
b) inserting the planar material into an exposure device (1) according to any of claims 1 to 10,
c) transporting the planar material (2) so that a first side (3) of the planar material (2) is supplied to a first exposure unit (10) and the first side (3) moves past the first exposure unit (10) and is exposed by the first exposure unit (10), wherein the first exposure unit (10) is rotatable about a pin (14) and is in a first position (11),
d) transporting the planar material (2) so that a second side (4) of the planar material (2) is supplied to the first exposure unit (10) and the second side (4) moves past the first exposure unit (10) and is exposed by the first exposure unit (10), wherein the first exposure unit (10), which is rotatable about a pin (14), is in a second position (12),
e) removing the planar material (2) from the exposure device (1),
wherein steps c) and d) can be carried out in any order and steps b) and e) can each be carried out at least partially in parallel with one of steps c) and d).

13. Method according to claim 12, **characterised in that** in step d) the planar material (2) is moved using a transport unit (30), and the first exposure unit (10) faces the transport unit (30) in the second position (12).

14. Method according to either claim 12 or claim 13, **characterised in that** while the planar material (2) is transported according to steps c) and/or d), the second side (4) is exposed using at least one further exposure unit (20, 22, 24).

15. Method according to any of claims 12 to 14, **characterised in that** while the planar material (2) is exposed by the first exposure unit (10), the second side is exposed using at least one further exposure unit (20, 22, 24).

## Revendications

1. Dispositif d'éclairage (1) pour éclairer un matériau (2) en forme de panneau, dans lequel le matériau (2) en forme de panneau présente un premier côté (3) et un deuxième côté (4) faisant face au premier côté (3) et dans lequel le dispositif d'éclairage (1) comprend une première unité d'éclairage (10) et une unité de transport (30), **caractérisé en ce que** la première unité d'éclairage (10) comprend au moins un segment avec une source de lumière et est réalisée de manière à pouvoir tourner autour d'un axe (14), dans lequel la première unité d'éclairage (10) peut adopter par la rotation autour de l'axe (14) une première position (11) et une deuxième position (12) et la première unité d'éclairage (10) ainsi que l'unité de transport (30) sont mises au point de telle manière que dans la première position (11) de la première unité d'éclairage (10), le premier côté (3) du matériau (2) en forme de panneau soit amené pour un éclairage et soit déplacé le long de la première unité d'éclairage (10) et dans la deuxième position (12) de la première unité d'éclairage (10), le deuxième côté (4) du matériau (2) en forme de panneau soit amené pour un éclairage et soit déplacé le long de la première unité d'éclairage (10).

2. Dispositif d'éclairage (1) selon la revendication 1, **caractérisé en ce que** le dispositif d'éclairage (1) comprend au moins une autre unité d'éclairage (20, 22, 24).

3. Dispositif d'éclairage (1) selon la revendication 1 ou 2, **caractérisé en ce que** la première unité d'éclairage (10) et/ou l'au moins une autre unité d'éclairage (20, 22, 24) sont mises au point pour éclairer une surface en forme de bande du matériau (2) en forme de panneau, dans lequel le côté long de la surface en forme de bande est orienté de manière perpendiculaire par rapport à une direction de transport du matériau (2) en forme de panneau.

4. Dispositif d'éclairage (1) selon l'une quelconque des revendications 1 à 3, **caractérisé en ce que** la première unité d'éclairage (10) et/ou au moins une autre unité d'éclairage (20, 22, 24) génèrent un rayonnement électromagnétique, dans lequel la longueur d'onde se situe de manière préférée dans la plage de 200 nm à 2000 nm et de manière particulièrement préférée le rayonnement électromagnétique est à bande étroite ou monochromatique avec une longueur d'onde de 350 nm, 360 nm, 365 nm, 370 nm, 375 nm, 385 nm, 395 nm, 400 nm, 405 nm, 532 nm, 830 nm, 1064 nm ou une combinaison d'au moins deux desdites longueurs d'onde.

5. Dispositif d'éclairage (1) selon l'une quelconque des revendications 1 à 4, **caractérisé en ce que** la première unité d'éclairage (10) et/ou au moins une autre unité d'éclairage (20, 22, 24) comprennent un segment ou plusieurs segments, dans lequel un segment comprend au moins une source de lumière choisie parmi le groupe constitué de lampes à pression élevée, de lampes à lumière flash, de lampes à basse pression, de lampes fluorescentes, de laser, de diodes électroluminescentes (DEL) et de combinaisons de ceux-ci.

6. Dispositif d'éclairage (1) selon l'une quelconque des revendications 1 à 5, **caractérisé en ce que** l'unité de transport (30) comprend un tambour (32) rotatif, dans lequel l'axe de rotation (14) de la première unité d'éclairage (10) s'étend de manière parallèle par rapport à l'axe de rotation du tambour (32), ou que l'unité de transport (30) est une bande transporteuse sans fin, dans lequel l'axe de rotation (14) de la première unité d'éclairage (10) est orienté de manière préférée de manière perpendiculaire par rapport à une direction de transport de la bande transporteuse sans fin et de manière parallèle par rapport à un plan de la bande transporteuse sans fin.

7. Dispositif d'éclairage (1) selon la revendication 6, **caractérisé en ce que** l'unité de transport (30) présente au moins un dispositif de fixation pour des matériaux (2) en forme de panneau choisi parmi une baguette de fixation, un dispositif de serrage, une fixation à ventouse sous vide ou une combinaison de plusieurs dispositifs de fixations.

8. Dispositif d'éclairage (1) selon la revendication 6 ou 7, **caractérisé en ce que** l'au moins une autre unité d'éclairage (20, 22, 24) est disposée de manière à pointer de telle manière en direction de l'unité de transport (30) que l'au moins une autre unité d'éclairage (20, 22, 24) soit mise au point pour un éclairage de matériaux (2) en forme de panneau disposés sur l'unité de transport (30).

9. Dispositif d'éclairage (1) selon l'une quelconque des revendications 6 à 8, **caractérisé en ce que** l'au moins une autre unité d'éclairage (20, 22, 24) est configurée en tant qu'un ensemble annulaire, lequel peut être coulissé le long de l'axe de rotation du tambour (32), dans lequel l'ensemble annulaire comprend des sources de lumière dirigées sur la surface du tambour (32), et/ou
**que** l'au moins une autre unité d'éclairage (20, 22, 24) est disposée de telle manière que celle-ci fasse face à la première unité d'éclairage (10) pour une des positions de la première unité d'éclairage (10).

10. Dispositif d'éclairage (1) selon l'une quelconque des revendications 1 à 9, **caractérisé en ce que** le dispositif d'éclairage (1) comprend en supplément une unité d'illustration (50).

11. Dispositif pour fabriquer des formes d'impression à partir d'un matériau (2) en forme de panneau, comprenant
- un dispositif d'éclairage (1) selon l'une quelconque des revendications 1 à 10 pour éclairer un premier côté (3) et un deuxième côté (4) du matériau (2) en forme de panneau,
- une unité de lavage et une unité de séchage ou une unité de développement.

12. Procédé pour éclairer des matériaux (2) en forme de bande comprenant les étapes
a) de fourniture d'un matériau (2) en forme de panneau,
b) d'introduction du matériau en forme de panneau dans un dispositif d'éclairage (1) selon l'une quelconque des revendications 1 à 10,
c) de transport du matériau (2) en forme de panneau de sorte qu'un premier côté (3) du matériau (2) en forme de panneau soit amené à une première unité d'éclairage (10) et que le premier côté (3) soit déplacé le long de la première unité d'éclairage (10) et soit éclairé par la première unité d'éclairage (10), dans lequel la première unité d'éclairage (10) peut être tournée autour d'un axe (14) et se trouve dans une première position (11),
d) de transport du matériau (2) en forme de panneau de sorte qu'un deuxième côté (4) du matériau (2) en forme de panneau soit amené à la première unité d'éclairage (10) et que le deuxième côté (4) soit déplacé le long de la première unité d'éclairage (10) et soit éclairé par la première unité d'éclairage (10), dans lequel la première unité d'éclairage (10) pouvant être tournée autour d'un axe (14) se trouve dans une deuxième position (12) ;
e) de retrait du matériau (2) en forme de panneau hors du dispositif d'éclairage (1),
dans lequel les étapes c) et d) sont exécutées dans un ordre quelconque et les étapes b) et e) peuvent être exécutées respectivement au moins en partie en parallèle par rapport à une des étapes c) et d).

13. Procédé selon la revendication 12, **caractérisé en ce que** lors de l'étape d), le matériau (2) en forme de panneau est déplacé en utilisant une unité de transport (30), et la première unité d'éclairage (10) est tournée vers l'unité de transport (30) dans la deuxième position (12).

14. Procédé selon la revendication 12 ou 13, **caractérisé en ce que**, alors que la matériau (2) en forme de panneau est transporté selon les étapes c) et/ou d), un éclairage du deuxième côté (4) est effectué en utilisant au moins une autre unité d'éclairage (20, 22, 24).

15. Procédé selon l'une quelconque des revendications 12 à 14, **caractérisé en ce que**, alors que le matériau (2) en forme de panneau est éclairé par la première unité d'éclairage (10), un éclairage du deuxième côté est effectué en utilisant au moins une autre unité d'éclairage (20, 22, 24).
